# EUROPEAN PATENT APPLICATION

(11) **EP 1 199 815 A1**
(43) Date of publication of application: **24.04.2002**
(21) Application number: 01936927.1
(22) Date of filing: 08.06.2001
(51) Int. Cl.: H04B 7/005, H03M 13/23

(54) **RECEIVER APPARATUS, TRANSMITTER APPARATUS, AND BASE STATION AND COMMUNICATION TERMINAL APPARATUSES USING THOSE RECEIVER AND TRANSMITTER APPARATUSES**

(30) Priority: 13.06.2000 JP 2000177658
(71) Applicant: MATSUSHITA ELECTRIC INDUSTRIAL CO., LTD., Kadoma-shi, Osaka 571-8501 (JP)
(72) Inventor: UESUGI, Mitsuru, Yokosuka-shi, Kanagawa 238-0048 (JP)
(74) Representative: Grünecker, Kinkeldey, Stockmair & Schwanhäusser Anwaltssozietät
(86) International application number: JP0104865
(87) International publication number: WO0197404

(57) **Abstract**

The maximum delay time of delayed waves is estimated by a channel estimation section (106). A coding section (101) performs convolutional coding of transmit data with a constraint length determined adaptively based on the multipath maximum delay time estimated by the channel estimation section (106), and transmits the transmit data, and also notifies information indicating the convolutional code constraint length to the receiving side. The receiving side simultaneously performs Viterbi decoding and equalization with a UDMV (153) in accordance with the constraint length reported by the transmitting side, and obtains received data. By this means it is possible to improve error correction capability in the UDMV without enlarging the scale of the apparatus.

## Description

### Technical Field

The present invention relates to a receiving apparatus that performs compensation of distortion due to multipath fading, and error correction, and a transmitting apparatus that performs data transmission to this receiving apparatus.

### Background Art

Overcoming multipath fading and improving transmission quality are essential tasks in the field of mobile communications. It is known that an equalizer is effective in overcoming multipath fading, and a method employing an error correcting code-especially a method that decodes a convolutional code with a Viterbi decoder-is effective in improving transmission quality.

With a conventional transmission apparatus, good-quality data transmission is achieved by compensating for distortion due to multipath fading with an equalizer such as an MLSE (Maximum Likelihood Sequence Estimator) or DFE (Decision Feedback Equalizer), and using error correction processing such as Viterbi decoding to correct errors that cannot be compensated for.

However, in the above-described transmission apparatuses, channel distortion compensation with an equalizer and error correction processing with a Viterbi decoder are carried out independently, with error correction decoding being performed after symbol determination has first been carried out with an equalizer, and there is thus a problem of performance degradation due to equalizer determination errors.

As a means of solving this problem, a "receiving apparatus and transmitting apparatus, and base station apparatus and communication terminal apparatus using these" are disclosed in Unexamined Japanese Patent Publication No.HEI 10-322253. The invention disclosed in above-mentioned Unexamined Japanese Patent Publication No.HEI 10-322253 supposes a virtual coder (UDMV: United Demodulator of MLSE and Viterbi Decoder) that combines a channel model and a convolutional coder, and by using this to perform Viterbi decoding, equalization by means of an MLSE and Viterbi decoding for a convolutional code are carried out simultaneously, thereby improving error correction capability.

In the above-described UDMV, extending the Viterbi decoding constraint length by increasing the number of delayers is considered as a means of improving error correction capability. However, with a conventional UDMV, it is not possible to increase delayers beyond a certain number due to limitations on the scale of the apparatus, and therefore there is a fixed limit to error correction capability.

### Disclosure of Invention

It is an object of the present invention to provide a UDMV that enables error correction capability to be improved without enlarging the scale of an apparatus, and a communication apparatus provided with this UDMV.

This object is achieved by having data coding and decoding performed, in a UDMV that simultaneously performs equalization that compensates for distortion due to multipath fading and Viterbi decoding of convolutional-coded data, so that convolutional coding and Viterbi decoding constraint lengths are at a maximum within a range in which a delayed wave with the estimated multipath maximum delay time can be equalized.

### Brief Description of Drawings

FIG. 1 is a drawing showing a schematic configuration of communication apparatuses according to Embodiment 1 of the present invention;
FIG.2 is a drawing showing the configuration of the functional blocks of a coding section according to Embodiment 1 of the present invention;
FIG.3 is a block diagram showing the configuration of a convolutional coder according to Embodiment 1 of the present invention;
FIG.4 is a drawing showing the configuration of the functional blocks of a UDMV provided in a communication apparatus according to Embodiment 1 of the present invention;
FIG.5 is a drawing showing the configuration of a virtual convolutional coder according to Embodiment 1 of the present invention;
FIG.6 is a drawing showing a schematic configuration of communication apparatuses according to Embodiment 2 of the present invention;
FIG.7 is a drawing showing the configuration of the functional blocks of a UDMV according to Embodiment 2 of the present invention;
FIG.8 is a drawing showing the configuration of the functional blocks of a coding section according to Embodiment 2 of the present invention;
FIG.9 is a drawing showing the configuration of the functional blocks of a coding section according to Embodiment 3 of the present invention;
FIG.10 is a drawing showing the configuration of the functional blocks of a UDMV according to Embodiment 3 of the present invention;
FIG.11 is a drawing showing a schematic configuration of communication apparatuses according to Embodiment 4 of the present invention;
FIG.12 is a block diagram showing the configuration of a coder according to Embodiment 4 of the present invention; and
FIG.13 shows an example of the frame configuration of transmit data and a training sequence according to Embodiment 5 of the present invention.

### Best Mode for Carrying out the Invention

Within a UDMV combining a convolutional coder and an MLSE equalizer, a part that has the same filter structure as an equalizer regards a signal resulting from delaying of a candidate signal by a delayer as a delayed wave and generates a replica of the received signal, compares this generated replica with the actual received signal, and determines the candidate signal that generates the replica most closely resembling the actual received signal to be the transmitted signal.

The present inventors arrived at the present invention by noting that delayers for generating replicas are provide together with the convolutional coder and equalizer combined in the above-described UDMV, and that some of the delayers used in equalization may not be used depending on the maximum delay time of a delayed wave, and finding that by using such an unused delayer as a convolutional coding delayer, the convolutional code constraint length can be increased, enabling Viterbi decoder error correction capability to be improved while keeping the apparatus scale constant.

That is to say, the subject of the present invention is improving error correction capability while keeping the UDMV apparatus scale constant by performing data coding and decoding, in a UDMV that simultaneously performs equalization that compensates for distortion due to multipath fading and Viterbi decoding of convolutional-coded data, so that convolutional coding and Viterbi decoding constraint lengths are at a maximum within a range in which a delayed wave with the estimated multipath maximum delay time can be equalized.

With reference now to the accompanying drawings, embodiments of the present invention will be explained in detail below.

### (Embodiment 1)

In this embodiment, a transmitting side estimates the maximum delay time of a delayed wave, performs convolutional coding of transmit data with a constraint length determined adaptively based on the estimated maximum delay time and transmits that transmit data, and also notifies information indicating the convolutional code constraint length to a receiving side. The receiving side simultaneously performs Viterbi decoding and equalization on the received signal with a UDMV (United Decoder with MLSE and Viterbi decoder) according to the constraint length notified by the transmitting side, and obtains received data.

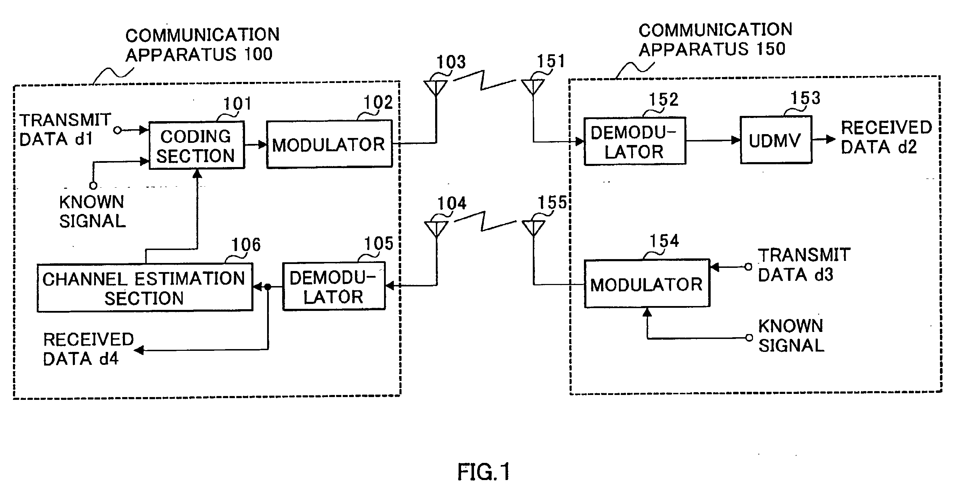

FIG.1 shows a schematic configuration of a communication apparatus 100, and a communication apparatus 150 provided with a UDMV, according to Embodiment 1 of the present invention. Communication apparatus 100 according to this embodiment performs convolutional coding of transmit data d1 in a coding section 101 using a constraint length determined based on the delayed wave maximum delay time. Communication apparatus 100 also performs frame configuration of a constraint length indication signal indicating the constraint length of convolutional coding performed by the coding section 101 together with transmit data and a known signal, performs modulation with a modulator 102, and transmits the resulting signal from a transmitting antenna 103.

Communication apparatus 150 inputs a received signal received from a receiving antenna 151 to a UDMV 153 via a demodulator 152, simultaneously performs compensation of distortion due to multipath fading and error correction by Viterbi decoding, and obtains received data d2. The UDMV 153 is a decoder that combines an MLSE equalizer and a Viterbi decoder, and carries out Viterbi decoding and equalization in accordance with the constraint length indicated by the received constraint length indication signal.

In addition, communication apparatus 150 modulates transmit data d3 and a known signal with a modulator 154, and transmits the resulting signal from a transmitting antenna 155. Communication apparatus 100 demodulates the received signal received by a receiving antenna 104 with a demodulator 105, and obtains received data d4. A channel estimation section 106 estimates the delayed wave maximum delay time due to multipath propagation based on the known signal contained in the received signal. The maximum delay time is the longest delay time among delayed waves present in a multipath. The actual control by which a constraint length is determined will be described in detail later herein. The coding section 101 determines a convolutional code constraint length adaptively based on the multipath maximum delay time obtained by the channel estimation section 106, and performs convolutional coding of transmit data d1 using the determined constraint length.

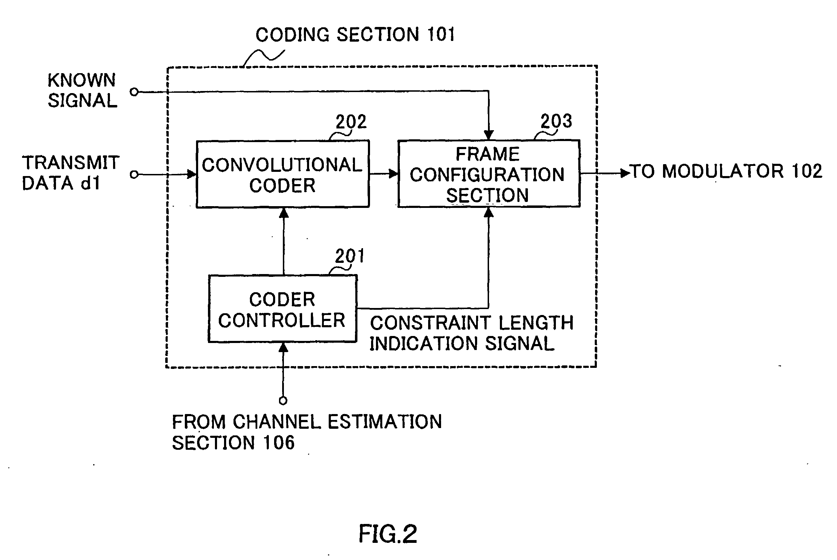

FIG.2 shows the configuration of the functional blocks of the coding section 101.

A coder controller 201 determines the constraint length for convolutional coding by a convolutional coder 202 based on a multipath maximum delay time obtained by the channel estimation section 106, and controls the convolutional coder 202 so that convolutional coding is performed using the determined constraint length. Meanwhile the coder controller 201 outputs to a frame configuration section 203 a constraint length indication signal indicating the constraint length in convolutional coding by the convolutional coder 202. The frame configuration section 203 performs frame configuration with the convolutional-coded transmit data output from the convolutional coder 202, the constraint length indication signal output from the coder controller 201, and a known signal, and outputs the resulting frame to the modulator 102.

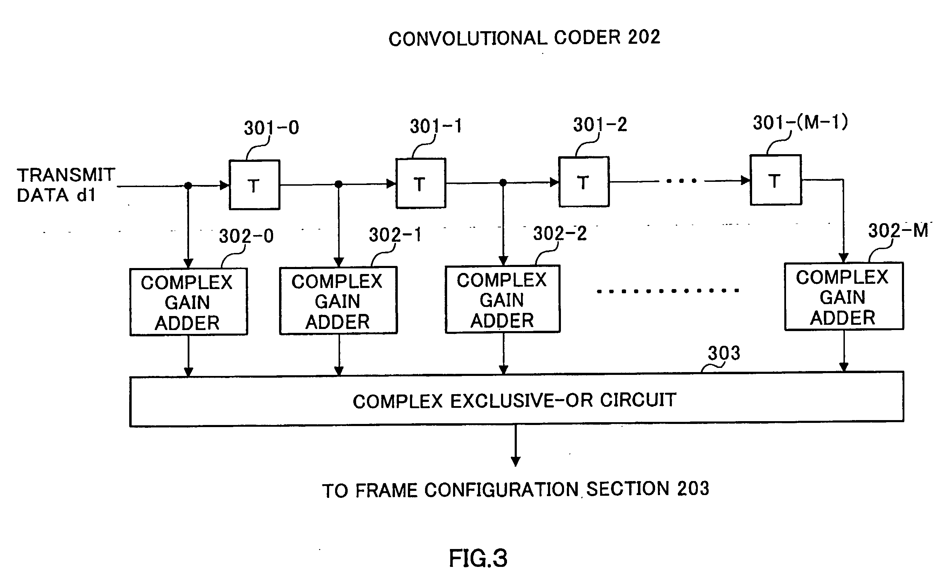

FIG.3 is a block diagram showing the configuration of the convolutional coder 202. As shown in this diagram, the convolutional coder 202 comprises M delayers 301-0 through 301-(M-1), (M+1) complex gain adders 302-0 through 302-M, and a complex exclusive-OR circuit 303.

The convolutional coder 202 generates a plurality of bits in accordance with a number of past bit states each time one transmit data bit enters . For example, when the code rate is 1/2, two bits are generated each time one transmit data bit enters. This is illustrated in FIG.3. Transmit data is delayed by delayers 301-0 through 301-(M-1), complex gain is added by complex gain adders 302-0 through 302-M, the complex exclusive-OR of the results is obtained by the complex exclusive-OR circuit 303, and a convolutional-coded signal is obtained. In the case of a convolutional coder only bit operations areused, so the complex gain coefficient (c ) set in complex gain adders 302-0 through 302-M is a value of 0, 1, or j. A complex gain coefficient (c) corresponding to the constraint length determined by the coder controller 201 is set in these complex gain adders 302-0 through 302-M. For example, when the constraint length is K, convolutional coding with constraint length K is implemented by setting 0 in complex gain adders 302-K through 302-M. By setting complex gain coefficient (c) to be set in complex gain adders 302-0 through 302-M adaptively according to the constraint length determined by the coder controller 201 in this way, it is possible for the convolutional coder 202 to perform convolutional coding of transmit data using a constraint length in accordance with the multipath maximum delay time. The convolutional coder 202 configured in this way can perform convolutional coding of transmit data d1 with a maximum constraint length of (M+1). The complex gain coefficient (c) set in each of complex gain adders 302-0 through 302-M is set so as to maximize the intersymbol distance in convolutional coding according to the constraint length.

The UDMV 153 knows beforehand the configuration of the convolutional coder 202, and can also learn the convolutional code constraint length by referring to the constraint length indication signal notify from communication apparatus 100, and so performs Viterbi decoding using the same constraint length as that used in convolutional coding.

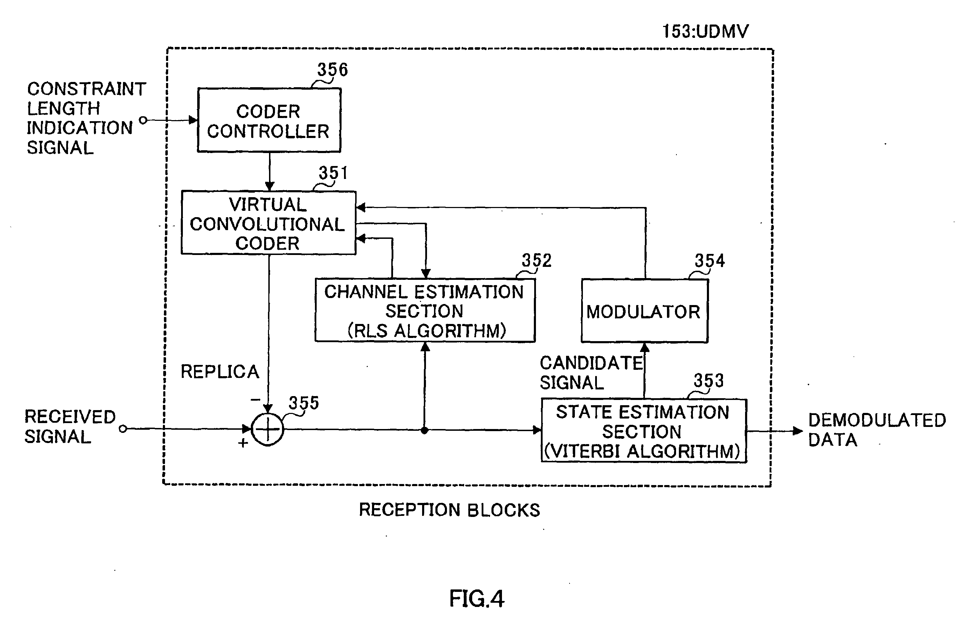

FIG.4 shows the configuration of the functional blocks of the UDMV 153 provided in communication apparatus 150. A coder controller 356 controls a virtual convolutional coder 351 so that Viterbi decoding is performed using the constraint length indicated by a constraint length indication signal contained in the received signal. The virtual convolutional coder 351 is a digital filter configured so as to have a state in which convolutional coder 202 and channel distortion are combined. The virtual convolutional coder 351 will be described in detail later herein. A channel estimation section 352 estimates a complex gain coefficient (p) using a known signal (unique word) inserted into the received signal, and sets this in the virtual convolutional coder 351. The complex gain coefficient (p) is a coefficient for compensating for channel distortion. A state estimation section 353 outputs a candidate signal corresponding to the number of bits of the received signal to a modulator 354,and the modulator 354 applies the same modulation to the candidate signal as in modulator 102, and inputs the resulting signal to the virtual convolutional coder 351. Meanwhile the state estimation section 353 takes from an adder 355 an error signal indicating the error between the replica from the virtual convolutional coder 351 and the actual received signal, selects a path that connects to a candidate with a small error, and outputs a data stream linked by the selected path as demodulated data.

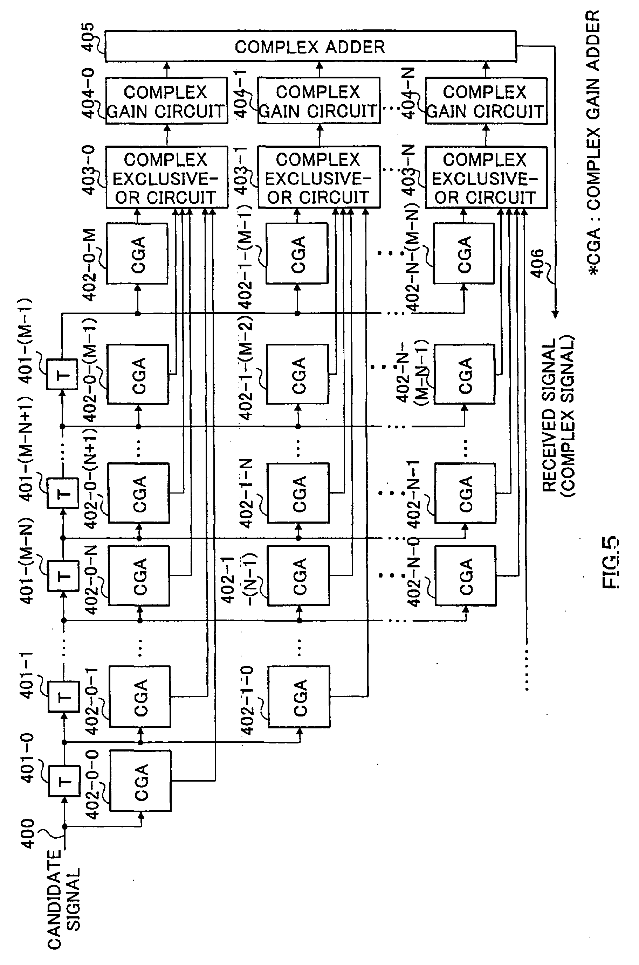

FIG.5 shows the configuration of the virtual convolutional coder 351 when QPSK modulation is used for modulation with a code rate of 1/2. In this figure, M is the number of delayers provided in the virtual convolutional coder 351, and N is a value obtained by dividing the longest delay time assumed beforehand from among multipath maximum delay times by the delay time per delayer provided in the UDMV 153.

The virtual convolutional coder 351 shown in this figure comprises a series of delayers in which M delayers 401-0 through 401-(M-1), the same as the number of delayers 301-0 through 301-(M-1) provided in the convolutional coder 202, are connected in series, a number (=N+1) of complex gain blocks corresponding to the assumed multipath maximum delay time, complex exclusive-OR circuits 403-0 through 403-N provided in correspondence to the complex gain blocks respectively, complex gain circuits 404-0 through 404-N that multiply the outputs of complex exclusive-OR circuits 403-0 through 403-N by a complex gain coefficient (p) that compensates for channel distortion, and a complex adder 405 that adds the outputs of complex gain circuits 404-0 through 404-N.

The first-level complex gain block comprises (M+1) complex gain adders 402-0-0 through 402-0-M (complex gain adder is abbreviated as CGA in FIG.5), the same as the number of complex gain adders 302-0 through 302-M in the convolutional coder 202. For each complex gain block, the number of component complex gain adders decreases by one in each successively lower level from the first level. For example, the block one level down from the first level comprises M complex gain adders 402-1-0 through 402-1-(M-1), and the lowest-level block N levels down comprises (M-N+1) complex gain adders 402-N-0 through 402-N-(M-N).

Under the control of the coder controller 356, these complex gain adders 402-0-0 through 402-0-M, 402-1-0 through 402-1-(M-1), ..... 402-N-0 through 402-N-(M-N) obtain a value of 0, 1, or j, corresponding to the complex gain coefficient (c) set in complex gain adders 302-0 through 302-M shown in FIG.3. If an arbitrary integer between 0 and N is designated X, and an arbitrary integer between 0 and (M-X) is designated Y, the correspondence is 402-X-Y = 302-Y. The complex gain coefficient (c) set in these complex gain adders 402-0-0 through 402-0-M, 402-1-0 through 402-1-(M-1), ..... 402-N-0 through 402-N-(M-N)is changed and set as appropriate according to the constraint length.

In complex gain adders 402-0-0 through 402-0-M comprising the first-level complex gain block, candidate signal 400 input to the first delayer 401-0 in the delayer series and delay data from delayers 401-0 through 401-(M-1) are input in parallel according to their order, and are multiplied in these complex gain adders 402-0-0 through 402-0-M by a complex gain coefficient (c). Complex exclusive-OR circuit 403-0 calculates the complex exclusive-OR of the outputs of complex gain adders 402-0-0 through 402-0-M. The same kind of processing is also carried out in the complex gain blocks in the second and subsequent levels.

That is to say, delayers 401-0 through 401-(M-1), first-level complex gain adders 402-0-0 through 402-0-M, and complex exclusive-OR circuit 403-0 in the virtual convolutional coder 351 have the same filter structure as the convolutional coder 202 shown in FIG.3. Second-level and subsequent delayers, complex gain adders, and complex exclusive-OR circuits also have the same kind of filter structure as convolutional coder 202.

In the virtual convolutional coder 351, delay data groups input to each complex gain block are shifted one delay at a time on a block-by-block basis from the first-level block through the lowest-level block. By regarding the delays due to delayers 401-0 through 401-N as delays in propagation paths corresponding to N delayed waves, delayers 401-0 through 401-N, complex gain circuits 404-0 through 404-N, and the complex adder 405, have the same filter structure as an equalizer that equalizes N delayed waves. In the UDMV 153, the channel estimation section 352 estimates a filter coefficient that will compensate for distortion according to the current state of each propagation path based on a known signal, and sets the complex gain (p) of complex gain circuits 404-0 through 404-N in the virtual convolutional coder 351.

The operation of data transmission apparatuses with the above configurations will now be described.

First, in communication apparatus 150, transmit data d3 is modulated by the modulator 154 and transmitted from the transmitting antenna 155. In communication apparatus 100, the direct wave and delayed waves of this signal are received by the receiving antenna 104. This received signal is demodulated by the demodulator 105 and received data d4 is obtained, and in addition, channel estimation is performed by the channel estimation section 106 and the multipath maximum delay time is estimated. In the coding section 101, a constraint length is determined based on the multipath maximum delay time estimated by the channel estimation section 106, and transmit data d1 undergoes convolutional coding using this constraint length. This convolutional-coded transmit data is subjected to frame configuration together with a constraint length indication signal and a known signal. This frame-configured signal is modulated by the modulator 102, and transmitted from the transmitting antenna 103.

In communication apparatus 150, the signal transmitted from communication apparatus 100 subjected to multipath distortion is received by the receiving antenna 151. This received signal is demodulated by the demodulator 152 and then subjected to Viterbi decoding using the constraint length indicated by the constraint length indication signal, and receive data d2 is obtained.

The operation of the coding section 101 will now be described.

In the coder controller 201, the constraint length of the convolutional coder 202 is determined according to the multipath maximum delay time estimated by the channel estimation section 106 and the known number of delayers provided in the UDMV 153. In the coder controller 201, the number of delayers J (1 . J . N) needed to equalize the estimated multipath delayed waves is calculated by dividing the multipath maximum delay time estimated by the channel estimation section 106 by the delay time per delayer provided in the virtual convolutional coder 351.

When the number of delayers needed to equalize multipath delayed waves is J, the virtual convolutional coder 351 generates a received signal replica using complex gain blocks from the first level to the (J+1)th level. That is to say, J delayers from among the M delayers 401-0 through 401-(M-1) provided in the virtual convolutional coder 351 are needed in order to output a delay data stream to first-level through (J+1)th-level complex gain blocks. Therefore, the remaining M-J delayers can be used as Viterbi decoding delayers. Thus, when the number of delayers needed to equalize multipath delayed waves calculated by the coder controller 201 is J, convolutional code constraint length K is determined to be M-J+1. That is to say, since K+J=M+1 (constant), control is performed so that the sum of the convolutional code constraint length K and the number of delayers needed for equalization J is constant. By determining the constraint length in this way, it is possible to perform convolutional coding with the longest constraint length in the estimated channel state. Actual control when determining the constraint length is not limited to the above-described control.

Meanwhile, the coder controller 201 sets a complex gain coefficient (c) of 0 in complex gain adders 302-(M-J+1) through 302-M so that the equation for the constraint length is K=M-J+1, and sets an appropriate complex gain coefficient (c) for convolutional coding in complex gain adders 302-0 through 302-(M-J). A constraint length indication signal indicating the determined constraint length (=K) is also generated by the coder controller 201, and is output to the frame configuration section 203.

In the convolutional coder 202, transmit data d1 is delayed in delayers 301-0 through 301-(M-1), and output to complex gain adders 302-0 through 302-M. The output delay data streams are multiplied by the complex gain coefficient (c) set by the coder controller 201 in complex gain adders 302-0 through 302-M and undergo complex exclusive-ORing by the complex exclusive-OR circuit 303, whereby a convolutional-coded signal is obtained. In this case, multiplication by 0 is performed in complex gain adders 302-K through 302-(M+N), and the outputs of complex gain adders 302-K through 302-(M+N) have no effect on the result of the addition, so that the convolutional coder 202 functions as a convolutional coder with constraint length K. The convolutional-coded signal undergoes frame configuration together with the constraint length indication signal and a known signal in the frame configuration section 203, and is then modulated by the modulator 102 and transmitted to communication apparatus 150.

Next, the operation of the UDMV 153 will be described.

The UDMV 153 has a state in which the convolutional coder 202 and channel distortion are combined, and simultaneously performs equalization by MLSE and error correction by Viterbi decoding. In the UDMV 153, the coder controller 356 controls complex gain adders 402-0-0 through 402-N-(M-N) in the virtual convolutional coder 351 so as to perform Viterbi decoding using the constraint length (K=M-J+1) indicated by the received constraint length indication signal. That is to say, according to the constraint length (K=M-J+1) indicated by the received constraint length indication signal, all-zeros are set in complex gain adders (402-0-K through 402-0-M) ..... (402-N-K through 402-N-14), and a complex gain coefficient (c) corresponding to complex gain adders 302-0 through 302-(K-1) in the convolutional coder 202 is set in complex gain adders (402-0-0 through 402-0-(K-1)) ..... (402-K-0 through 402-K-(K-1)). Also, all-zeros are set in complex gain adders 402-(J+1)-0 through 402-(J+1)-M in level J+1 onward. By setting the complex gain coefficient (c) in this way, the virtual convolutional coder 351 delayers, each-level complex gain adders, and each-level complex exclusive-OR circuits each have the same filter structure as the convolutional coder 202, enabling Viterbi decoding of a signal that has undergone convolutional coding using constraint length K.

In the UDMV 153 in which the complex gain coefficient (c) is set in this way, a candidate signal 400 conveyed from the state estimation section 353 is input to delayer 401-0 in the first level of the delayer series via the modulator 354, and delayed sequentially by delayers 401-0 through 401-(M-1). Multiplication by complex gain (c) is first performed by complex gain adders 402-0-0 through 402-N-(M-N), then the complex exclusive-ORs of the real and imaginary parts are found for all signals by complex exclusive-OR,circuits 403-0 through 403-N. Complex gain adders 402-0-0 through 402-J-(M-J) correspond to complex gain adders 302-0 through 302-M, and give only a value of 0, 1, or j. If an arbitrary integer between 0 and J is designated Z, and an arbitrary integer between 0 and M-Z is designated Y, the correspondence is 402-X-Y=302-Y.

Complex exclusive-OR circuits 403-0 through 403-N perform the following operations on the outputs of complex gain adders 402-0-0 through 402-N-(M-N).
403-0: Complex exclusive-OR of 402-0-0 through 402-0-M
403-1: Complex exclusive-OR of 402-1-0 through 402-1-M-1
403-N: Complex exclusive-OR of 402-N-0 through 402-N-(M-N)

Complex exclusive-OR circuits 403-(J+1) through 403-N need not perform operations since only 0 is output from the complex gain adders.

The outputs of complex exclusive-OR circuits 403-0 through 403-N are next further multiplied by gain (p) in complex gain circuits 404-0 through 404-N.

The outputs of complex gain circuits 404-0 through 404-N are all added by the complex adder 405 to give a received signal (replica) 406.

Thus, according to this embodiment, the number of delayers used for equalization from among the delayers provided in the UDMV 153 is obtained from the multipath maximum delay time estimated by the coding section 101, and the convolutional code constraint length is calculated by using the remaining delayers as convolutional coding delayers. Therefore, all delayers other than those needed for equalization are controlled as convolutional coding delayers based on a fixed number of delayers according to the estimated multipath maximum delay time, enabling convolutional coding to be performed with the maximum constraint length that can be decoded by the UDMV 153. Also, since the constraint length calculated by communication apparatus 100 in this way is reported to communication apparatus 150, the UDMV 153 provided in communication apparatus 150 can simultaneously perform Viterbi decoding with the constraint length used in convolutional coding and equalization of the estimated delay time.

In above Embodiment 1, a case where QPSK modulation is used for modulation with a code rate of 1/2 is given as an example, but a virtual coder can also be constructed in other cases using a similar concept.

### (Embodiment 2)

In Embodiment 1, a multipath maximum delay time is estimated based on a transmit signal from a communication apparatus provided with a UDMV to a communication apparatus not provided with a UDMV, and the constraint length for convolutional coding of a signal transmitted from a communication apparatus not provided with a UDMV to a communication apparatus provided with a UDMV is calculated. Therefore, it is necessary for the constraint length to be reported from communication apparatus 100 that performs coding to communication apparatus 150 provided with a UDMV.

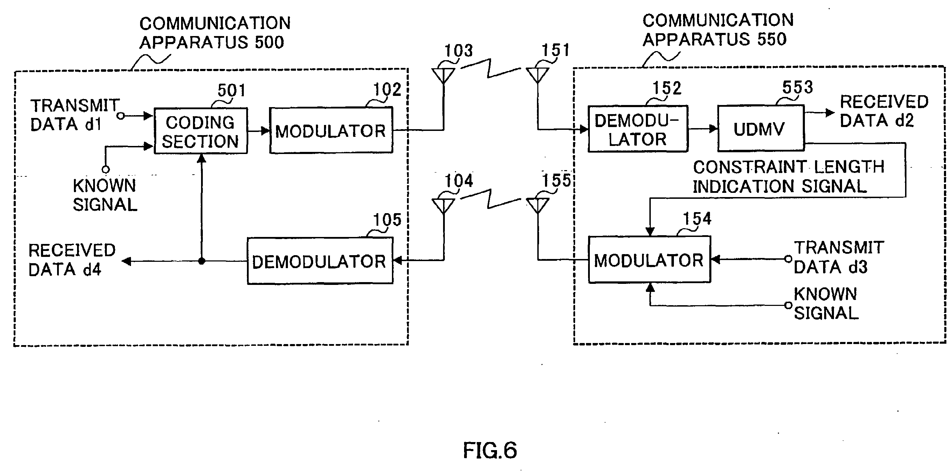

Thus, in this embodiment, the receiving side estimates the delayed wave maximum delay time, determines the Viterbi decoding constraint length based on the estimated maximum delay time, and performs Viterbi decoding of a received signal in a UDMV using this determined constraint length to obtain received data. The receiving side conveys information indicating the Viterbi decoding constraint length to the transmitting side. The transmitting side performs convolutional coding on transmit data using the Viterbi decoding constraint length reported from the receiving side, and transmits the transmit data. That is to say, this embodiment differs from Embodiment 1 in that it is the communication apparatus provided with a UDMV that determines the constraint length. This embodiment therefore differs from Embodiment 1 in that there is no need for a constraint length to be reported from the communication apparatus that performs coding to the communication apparatus provided with a UDMV. Communication apparatuses according to this embodiment will be described below with reference to FIG.6 through FIG.8. Parts in FIG.6 through FIG.8 identical to those in FIG.1 through FIG.5 are assigned the same codes as in FIG.1 through FIG.5 and their detailed explanations are omitted.

FIG.6 shows a schematic configuration of a communication apparatus 500, and a communication apparatus 550 provided with a UDMV, according to Embodiment 2 of the present invention. Communication apparatus 500 according to this embodiment demodulates a received signal received by a receiving antenna 104 in a demodulator 105 and obtains received data d4. Also, in a coding section 501, a signal indicating the constraint length used in convolutional coding contained in the received signal is referenced, and convolutional coding is performed on transmit data d1.

Communication apparatus 550 inputs a received signal received by a receiving antenna 151 to a UDMV 553 via a demodulator 152, and in the UDMV 553 the maximum delay time of delayed waves due to multipath propagation is estimated based on a known signal contained in the received signal. Then the number of delayers needed for equalization by the UDMV is calculated by dividing the estimated maximum delay time by the delay time per delayer provided in the UDMV 553, and the Viterbi decoding constraint length is determined corresponding to that number of delayers needed for equalization. The UDMV 553 simultaneously performs compensation of distortion due to multipath fading and error correction by means of Viterbi decoding in accordance with the determined constraint length, and obtains received data d2. Communication apparatus 550 also performs frame configuration with a constraint length indication signal indicating the constraint length for convolutional coding performed by the coding section 501, transmit data and a known signal, and after demodulation by a modulator 154, transmits the resulting frame from a transmitting antenna 155.

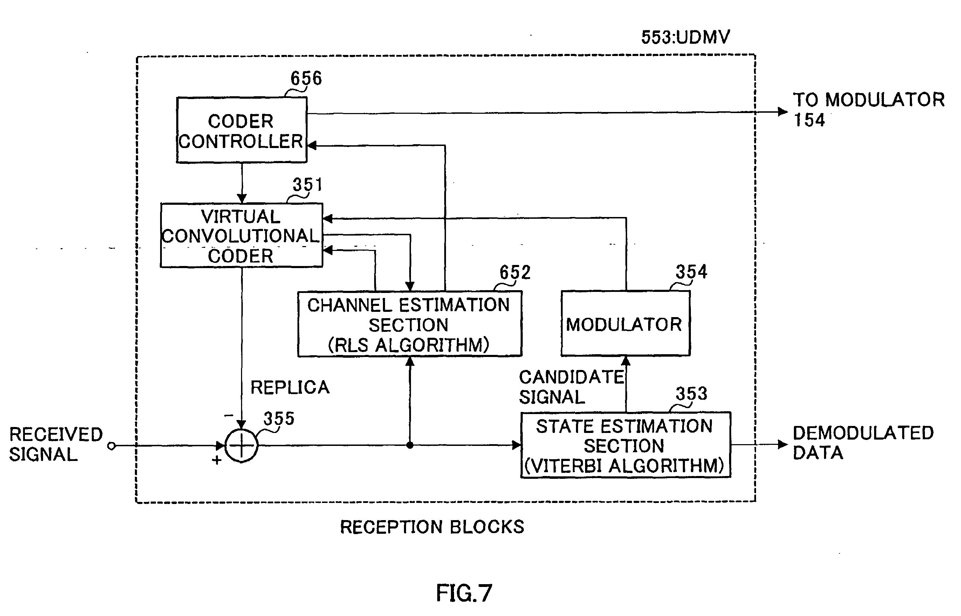

FIG.7 shows the configuration of the functional blocks of the UDMV 553 provided in communication apparatus 550. Achannel estimation section 652 estimates a complex gain coefficient (p) using a known signal (unique word) inserted into the received signal and sets this in a virtual convolutional coder 351, and also estimates the multipath maximum delay time. A coder controller 656 refers to the multipath maximum delay time calculated by the channel estimation section 652 and determines the constraint length for Viterbi decoding by the virtual convolutional coder 351, and controls the virtual convolutional coder 351 so that convolutional coding is carried out using the determined constraint length. The coder controller 656 also outputs a constraint length indication signal indicating the virtual convolutional coder 351 constraint length to the transmission sequence modulator 154. A state estimation section 353 outputs a candidate signal corresponding to the number of bits of the received signal to a modulator 354, and the modulator 354 applies the same modulation to the candidate signal as in modulator 102, and inputs the resulting signal to the virtual convolutional coder 351. Meanwhile the state estimation section 353 takes from an adder 355 an error signal indicating the error between the replica from the virtual convolutional coder 351 and the actual received signal, selects a path that connects to a candidate with a small error, and outputs a data stream linked by the selected path as demodulated data. Thus, the UDMV 553 estimates the multipath maximum delay time based on a known signal contained in the received signal, determines the Viterbi decoding constraint length based on this estimated delay time, and also generates a constraint length indication signal indicating the determined constraint length, which it outputs to modulator 154. After demodulation by modulator 154, the constraint length indication signal is transmitted from the transmitting antenna 155 to communication apparatus 500.

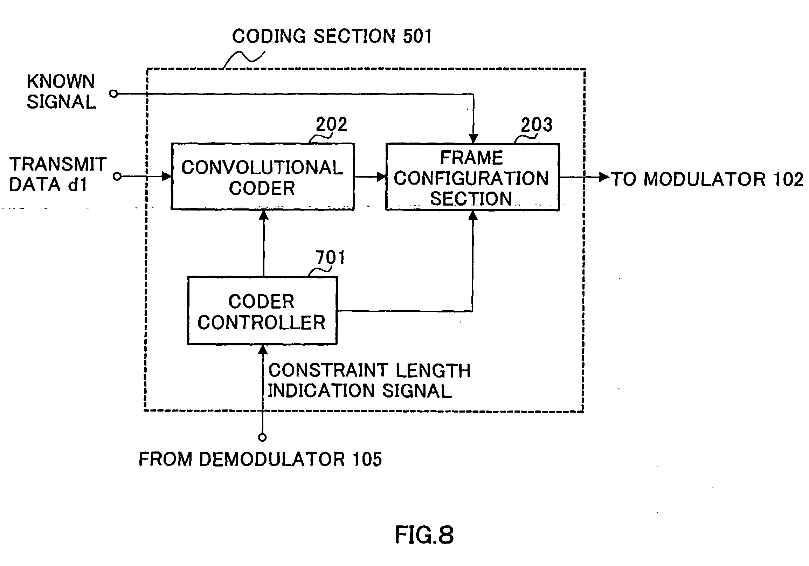

FIG.8 shows the configuration of the functional blocks of the coding section 501.

A coder controller 701 controls a convolutional coder 202 so that convolutional coding is performed using the constraint length indicated by the constraint length indication signal contained in the received signal demodulated by demodulator 105. The convolutional coder 202 performs convolutional coding of transmit data d1 using a constraint length in accordance with control by the coder controller 701 in the same way as in Embodiment 1, and outputs the resulting signal to a frame configuration section 203. The frame configuration section 203 performs frame configuration with the convolutional-coded transmit data output from the convolutional coder 202 and a known signal, and outputs the resulting frame to the modulator 102. The UDMV 553 simultaneously performs Viterbi decoding and equalization on the signal subjected to convolutional coding in this way, and obtains demodulated data.

Thus, according to this embodiment, communication apparatus 550 provided with a UDMV 553 estimates the multipath maximum delay time and calculates the Viterbi decoding constraint length according to that estimated delay time. It is therefore possible for a received signal to be demodulated by the UDMV without constraint length notification being received from communication apparatus 500.

### (Embodiment 3)

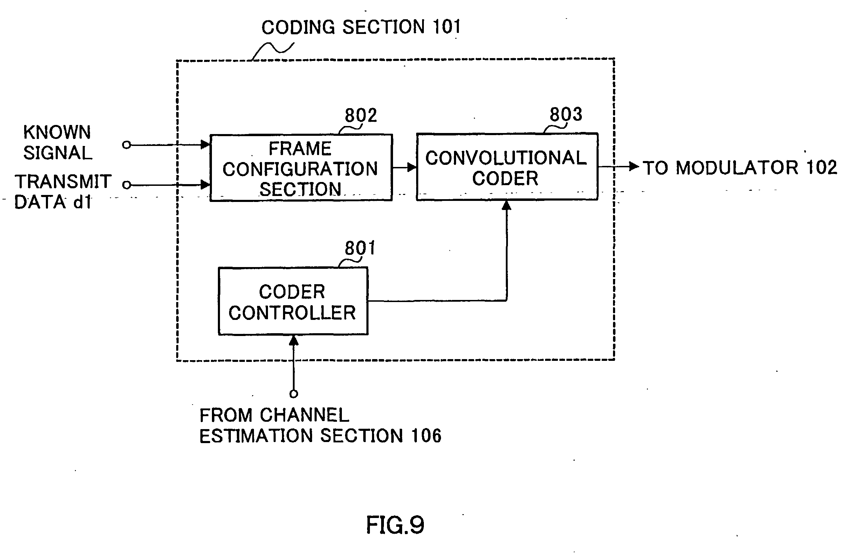

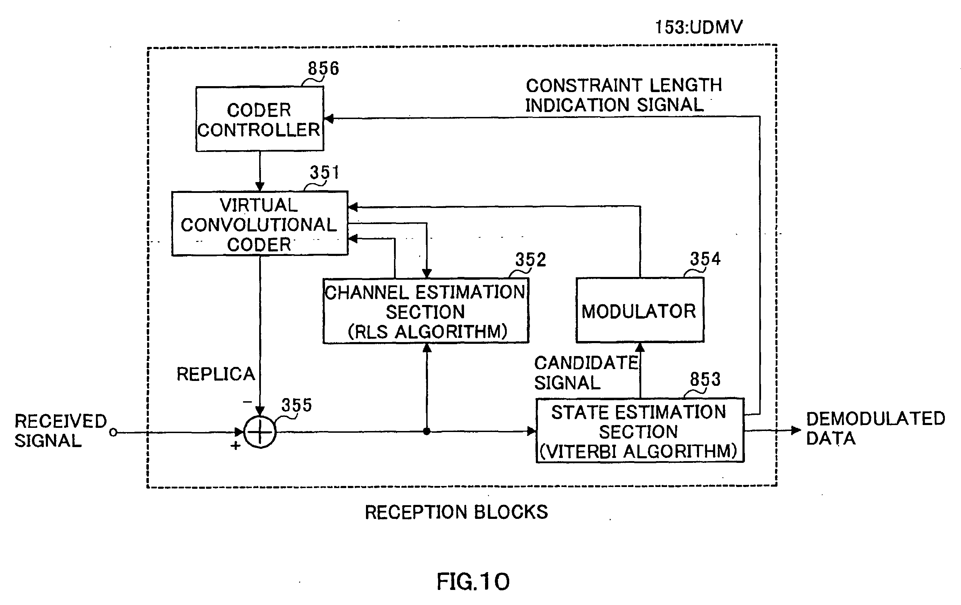

Communication apparatuses according to this embodiment have almost the same configuration as in Embodiment 1, but differ from Embodiment 1 in that the delayed wave maximum delay time is estimated in a coding section, and not only transmit data but also a known signal are subjected to convolutional coding using a constraint length determined adaptively based on the estimated maximum delay time. Communication apparatuses according to this embodiment will be described below with reference to FIG.9 and FIG.10. Parts in FIG.9 and FIG.10 identical to those in FIG.1 through FIG.5 are assigned the same codes as in FIG.1 through FIG.5 and their detailed explanations are omitted.

FIG.9 shows they configuration of the functional blocks of a coding section 101 according to Embodiment 3.

A coder controller 801 refers to the multipath maximum delay time calculated by a channel estimation section 106 and determines the constraint length of a virtual convolutional coder 803, and controls the virtual convolutional coder 803 so that convolutional coding is carried out using the determined constraint length. A frame configuration section 802 performs frame configuration with transmit data d1 and a known signal, and outputs the resulting frame to the virtual convolutional coder 803. The virtual convolutional coder 803 performs convolutional coding of the transmit data and known signal input from the frame configuration section 802 using a constraint length in accordance with control by the coder controller 801, and outputs a convolutional-coded signal to a modulator 102.

FIG.10 shows the configuration of the functional blocks of a UDMV 153 according to Embodiment 3. First, a state estimation section 853 outputs a candidate signal of a known signal contained in the transmit signal to a modulator 354,and the modulator 354 applies the same modulation to the candidate signal as in modulator 102, and inputs the resulting signal to a virtual convolutional coder 351. A coder controller 856 performs control to change the constraint length sequentially from 1 through M each time a candidate signal is input to the virtual convolutional coder 351. The virtual convolutional coder 351 sequentially generates a replica of the candidate signal with a constraint length in accordance with control by the coder controller 856 each time a candidate signal is input. The state estimation section 853 takes from an adder 355 an error signal indicating the error between the known signal replica from the virtual convolutional coder 351 and the actual known signal contained in the received signal, selects a path that connects to a candidate with a small error, and estimates the constraint length at the time of generation of a data stream linked by the selected path as the constraint length of the virtual convolutional coder 803. The state estimation section 853 outputs a signal indicating the estimated constraint length to the coder controller 856 as a constraint length indication signal, and also outputs a candidate signal in accordance with the number of bits of the received signal to the virtual convolutional coder 351 via the modulator 354. The coder controller 856 controls the constraint length used in Viterbi decoding by the virtual convolutional coder 351 according to the constraint length indicated by the constraint length indication signal. The virtual convolutional coder 351 generates a received signal candidate signal replica in accordance with control by the coder controller 856. The state estimation section 853 takes from the adder 355 an error signal indicating the error between the replica from the virtual convolutional coder 351 and the actual received signal, selects a path that connects to a candidate with a small error, and outputs a data stream linked by the selected path as demodulated data.

Thus, according to this embodiment, a known signal is also convolutional-coded and transmitted by the transmitting side, and therefore on the receiving side replicas of the known signal are generated, changing the constraint length sequentially, the generated replicas and the known signal contained in the received signal are compared, and the constraint length used when the replica most closely resembling the actual signal is generated is estimated as the constraint length used in convolutional coding. Therefore, in this embodiment, the constraint length used in convolutional coding is known, and Viterbi decoding and equalization can be carried out by the UDMV without constraint length information being sent from the transmitting side to the receiving side, even when convolutional coding is performed with the constraint length changed on the transmitting side.

### (Embodiment 4)

Communication apparatuses according to this embodiment have almost the same configuration as in Embodiment 1, but differ from Embodiment 1 in that the convolutional coder 202 finds the ordinary logical sum (inclusive-OR), not the exclusive logical sum (exclusive-OR), of a delay data stream. Also a value other than 1, 0, or j is possible for a gain coefficient. A communication apparatus 950 is provided with an equalizer 902 instead of the UDMV in Embodiment 1. An MLSE is desirable as the equalizer 902.

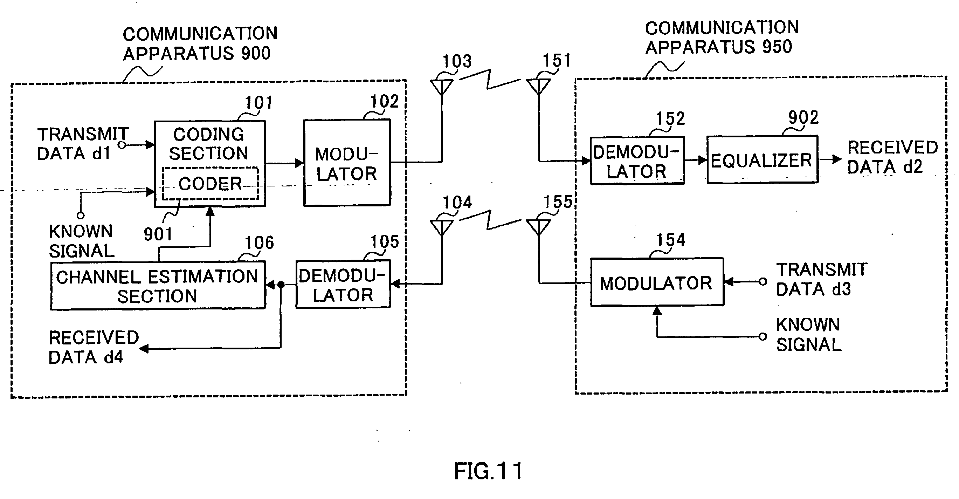

FIG.11 shows a schematic configuration of a communication apparatus 900, and a communication apparatus 950 provided with an equalizer 902, according to Embodiment 4 of the present invention. In communication apparatus 900, transmit data d1 is coded by a coder 901 provided in a coding section 101, and is transmitted to communication apparatus 950. In communication apparatus 950, the received signal is equalized by the equalizer 902 and received data d2 is obtained.

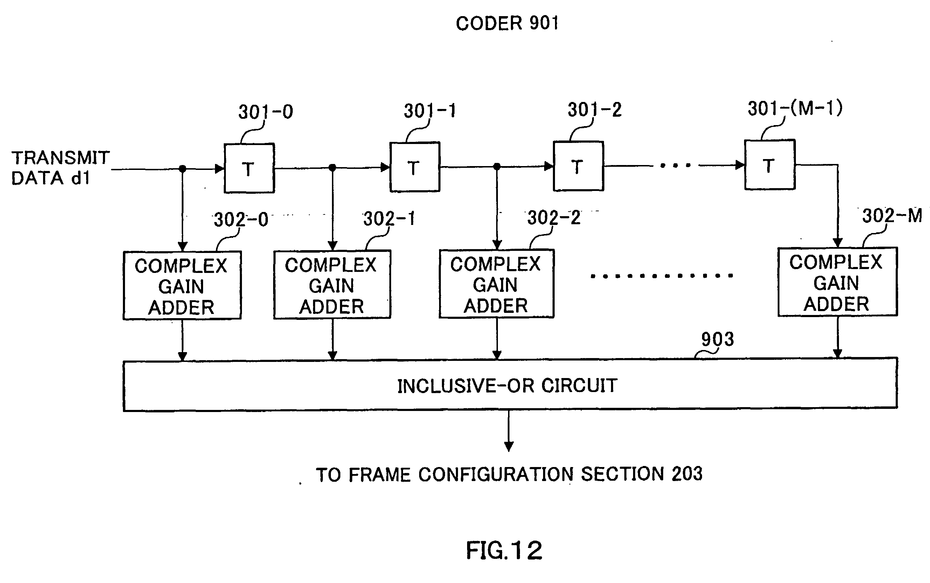

FIG.12 is a block diagram showing the configuration of the coder 901, which has a code rate of 1/2. In the coder 901, transmit data is delayed by delayers 301-0 through 301-(M-1), complex gain is added by complex gain adders 302-0 through 302-M, the inclusive-OR of the results is obtained by an inclusive-OR circuit 903, and a coded signal is obtained. A complex gain coefficient can have a value other than 0, 1, or j, including a negative value, may have a value in both the real and imaginary parts of a complex number, and is set so that the intersymbol distance is large. As delay due to delayers 301-0 through 301-(M-1) can be regarded as delay in the channel, the complex gain coefficients used in multiplication in complex gain adders 302-0 through 302-M can be regarded as distortion applied to the transmit signal in the channel, and the inclusive-OR operation performed by the inclusive-OR circuit 903 can be regarded as overlapping of delayed waves, the coder 901 is the same as an actual multipath delay model.

By this means, the equalizer 902 can estimate a transmission function with the actual channel and the coder 901 regarded as a single channel. A transmission function is estimated by performing channel estimation using a known signal. The equalizer 902 can compensate for multipath distortion and equalize a received signal using a transmission function estimated in this way.

Thus, according to this embodiment, it is possible to estimate a transmission function that includes a coder 901, equalize a received signal and obtain received data, even when the number of delayers used in coding is changed according to the channel state in the coder 901. That is to say, it is possible to equalize a received signal coded with the number of delays changed as appropriate in the coder without changing the configuration of the equalizer 902.

When a coder 901 according to this embodiment is installed in a base station, and an equalizer 902 is installed in a communication terminal, it is possible to perform communication of a signal coded with the number of delays changed according to the characteristics of the location where the base station is installed, and communication quality can be improved.

### (Embodiment 5)

Communication apparatuses according to this embodiment have almost the same configuration as in Embodiment 4, but differ from Embodiment 4 in that frame configuration is performed using transmit data d1 coded by the coding section 101 together with a training sequence that is a known signal.

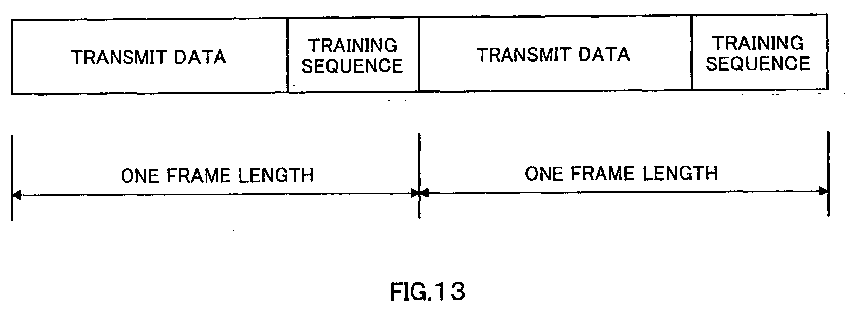

FIG.13 shows an example of the frame configuration of transmit data d1 and a training sequence. A training sequence is inserted at the start of each frame. A communication apparatus 900 transmits a transmit signal that has undergone frame configuration in this way to a communication apparatus 950.

An equalizer 902 generates a replica using a candidate signal corresponding to the training sequence, and estimates a channel transmission function by comparing the replica with the training sequence inserted in the received signal.

Thus, in this embodiment, inserting a known training sequence in a transmit signal and estimating a transmission function enables the transmission function to be estimated accurately based on an error-free determination result. Thus, received signal equalization can be performed by means of an accurately estimated transmission function, making it possible to compensate for channel distortion more accurately and perform communication from which the influence of delayed waves due to multipath fading has been eliminated.

In above Embodiment 4 and Embodiment 5, a UDMV may be used instead of the equalizer 902.

As described above, according to the present invention equalization that compensates for distortion due to multipath fading and Viterbi decoding of convolutional-coded data are performed simultaneously with the constraint length used in Viterbi decoding maximized within a range in which a delayed wave with the estimated multipath maximum delay time can be equalized, thereby enabling error correction capability to be improved in a UDMV without enlarging the scale of the apparatus.

This application is based on Japanese Patent Application No. 2000-177658 filed on June 13, 2000, entire content of which is expressly incorporated by reference herein.

### Industrial Applicability

The present invention is suitable for use in a receiving apparatus that performs compensation of distortion due to multipath fading and error correction, and a transmitting apparatus that performs data transmission to this receiving apparatus.

## Claims

1. A transmitting apparatus that performs radio communication with a communicating party provided with demodulating means for simultaneously performing equalization that compensates for distortion due to multipath fading and Viterbi decoding of convolutional-coded data, said transmitting apparatus comprising:
constraint length determining means for determining a convolutional code constraint length so that a constraint length used at the time of Viterbi decoding is maximized within a range in which it is possible to equalize distortion due to a delayed wave with a maximum delay time in said demodulating means; and
coding means for performing convolutional coding of transmit data using a constraint length determined by said constraint length determining means.

2. The transmitting apparatus according to claim 1, further comprising channel estimating means for estimating a maximum delay time of a delayed wave of a channel, wherein said constraint length determining means determines a convolutional code constraint length so that a constraint length used at the time of Viterbi decoding is maximized within a range in which it is possible to equalize distortion due to a delayed wave with a maximum delay time estimated by said channel estimating means in said demodulating means provided in a communicating party.

3. The transmitting apparatus according to claim 1 or claim 2, further comprising transferring means for transferring to a communicating party a constraint length determined by said constraint length determining means.

4. The transmitting apparatus according to claim 1 or claim 2, wherein said coding means performs convolutional coding of transmit data using a constraint length transferred by a communicating party.

5. The transmitting apparatus according to claim 1 or claim 2, wherein said coding means performs convolutional coding of both transmit data and a known signal.

6. The transmitting apparatus according to claim 1 or claim 2, wherein said coding means codes delayed transmit data by means of a linear operation.

7. A receiving apparatus comprising:
receiving means for receiving a signal transmitted by the transmitting apparatus according to claim 1; and
demodulating means for simultaneously performing equalization that compensates for distortion due to multipath fading and Viterbi decoding of convolutional-coded data;
wherein said demodulating means performs Viterbi decoding of a signal transmitted from said transmitting apparatus received by said receiving means, using a constraint length used in said transmitting apparatus .

8. A receiving apparatus comprising:
demodulating means for simultaneously performing equalization that compensates for distortion due to multipath fading and Viterbi decoding of convolutional-coded data;
channel estimating means for estimating a maximum delay time of a delayed wave of a channel;
constraint length determining means for determining a convolutional code constraint length so that a constraint length used at the time of Viterbi decoding is maximized within a range in which it is possible to equalize distortion due to a delayed wave with a maximum delay time estimated by said channel estimating means in said demodulating means; and
transferring means for transferring to a communicating party a constraint length determined by said constraint length determining means.

9. A receiving apparatus comprising:
receiving means for receiving a signal transmitted by the transmitting apparatus according to claim 5;
demodulating means for simultaneously performing equalization that compensates for distortion due to multipath fading and Viterbi decoding of convolutional-coded data; and
constraint length estimating means for referencing a convolutional pattern of a known signal contained in a received signal received by said receiving means and estimating a constraint length used by said transmitting apparatus;
wherein said demodulating means performs Viterbi decoding with a constraint length estimated by said constraint length estimating means.

10. A receiving apparatus comprising:
receiving means for receiving a signal transmitted by the transmitting apparatus according to claim 6; and
demodulating means for compensating for distortion in multipath propagation reaching a receiving antenna of the apparatus itself from a transmitting antenna of said transmitting apparatus and also performing equalization for a linear operation at the time of coding.

11. A base station apparatus equipped with a transmitting apparatus that performs radio communication with a communicating party provided with demodulating means for simultaneously performing equalization that compensates for distortion due to multipath fading and Viterbi decoding of convolutional-coded data, said transmitting apparatus comprising:
constraint length determining means for determining a convolutional code constraint length so that a constraint length used at the time of Viterbi decoding is maximized within a range in which it is possible to equalize distortion due to a delayed wave with a maximum delay time in said demodulating means; and
coding means for performing convolutional coding of transmit data using a constraint length determined by said constraint length determining means.

12. A communication terminal apparatus equipped with a transmitting apparatus that performs radio communication with a communicating party provided with demodulating means for simultaneously performing equalization that compensates for distortion due to multipath fading and Viterbi decoding of convolutional-coded data, said transmitting apparatus comprising:
constraint length determining means for determining a convolutional code constraint length so that a constraint length used at the time of Viterbi decoding is maximized within a range in which it is possible to equalize distortion due to a delayed wave with a maximum delay time in said demodulating means; and
coding means for performing convolutional coding of transmit data using a constraint length determined by said constraint length determining means.

13. A base station apparatus equipped with a receiving apparatus, said receiving apparatus comprising:
demodulating means for simultaneously performing equalization that compensates for distortion due to multipath fading and Viterbi decoding of convolutional-coded data;
channel estimating means for estimating a maximum delay time of a delayed wave of a channel;
constraint length determining means for determining a convolutional code constraint length so that a constraint length used at the time of Viterbi decoding is maximized within a range in which it is possible to equalize distortion due to a delayed wave with a maximum delay time estimated by said channel estimating means in said demodulating means; and
transferring means for transferring to a communicating party a constraint length determined by said constraint length determining means.

14. A communication terminal apparatus equipped with a receiving apparatus, said receiving apparatus comprising:
demodulating means for simultaneously performing equalization that compensates for distortion due to multipath fading and Viterbi decoding of convolutional-coded data;
channel estimating means for estimating a maximum delay time of a delayed wave of a channel;
constraint length determining means for determining a convolutional code constraint length so that a constraint length used at the time of Viterbi decoding is maximized within a range in which it is possible to equalize distortion due to a delayed wave with a maximum delay time estimated by said channel estimating means in said demodulating means; and
transferring means for transferring to a communicating party a constraint length determined by said constraint length determining means.

15. A transmitting method comprising the steps of:
determining a convolutional code constraint length so that a constraint length used at the time of Viterbi decoding is maximized within a range in which it is possible to equalize distortion due to a delayed wave with a maximum delay time in a receiving side that simultaneously performs equalization that compensates for distortion due to multipath fading and Viterbi decoding of convolutional-coded data; and
performing convolutional coding of transmit data using a determined constraint length and transmitting said transmit data to said receiving side.
